# EUROPEAN PATENT APPLICATION

(11) **EP 4 513 532 A1**
(43) Date of publication of application: **26.02.2025**
(21) Application number: 24154583.9
(22) Date of filing: 30.01.2024
(51) Int. Cl.: H01L 21/56, G02B 6/42

(54) **PHOTONICS CHIP PACKAGE STRUCTURES INCLUDING A CONTROLLED UNDERFILL FILLET**

(30) Priority: 23.08.2023 US 202318236985
(71) Applicant: GlobalFoundries U.S. Inc., Malta, NY 12020 (US)
(72) Inventor: MACHANI, Kashi Vishwanath, 01109 Dresden (DE); KÜCHENMEISTER, Frank, 01109 Dresden (DE)
(74) Representative: Lambacher, Michael

(57) **Abstract**

Structures for a packaged photonics chip and associated methods. The structure comprises a photonics chip, a packaging substrate, a plurality of electrical connections disposed in a gap between the photonics chip and the packaging substrate, and a fillet comprising an underfill material. The fillet is disposed to overlap with a portion of the photonics chip adjacent to the gap, the fillet has a width dimension and a height dimension transverse to the width dimension, and a ratio of the width dimension to the height dimension is greater than or equal to 1.5.

## Description

### BACKGROUND

The present disclosure relates generally to semiconductor devices and integrated circuit fabrication and, more specifically, to structures for a packaged photonics chip and associated methods.

Photonics chips are used in many applications and systems including, but not limited to, data communication systems and data computation systems. A photonics chip includes a photonic integrated circuit comprised of photonic components, such as modulators, polarizers, and optical couplers, that are used to manipulate light received from a light source, such as an optical fiber or a laser.

A photonics chip may be mounted on a laminate substrate to create a package assembly. Typically, solder joints are formed by reflowing solder to connect pads on the laminate substrate and the photonics chip. The solder joints provide electrical connections between the laminate substrate and photonics chip, but also create a gap between the laminate substrate and the photonics chip.

Filling the gap with an underfill material improves the reliability of the electrical connections between the photonics chip and the laminate substrate. Underfilling isolates the electrical connections from exposure to the ambient environment and lends mechanical strength to the package assembly. The underfill material also increases the fatigue life of the package assembly and reduces the stress experienced by the electrical connections during thermal cycling when the photonics chip and the laminate substrate have significantly different coefficients of thermal expansion. As a result, underfilling may significantly increase the operational lifetime of the package assembly.

Underfill material may be introduced into the gap by capillary action. A low-viscosity fluid underfill material may be pre-heated and dispensed onto a surface of the laminate substrate adjacent to one or more side edges of the photonics chip. Capillary action cause the fluid underfill material to flow into the gap. After the gap is filled, additional fluid underfill material may be dispensed about the perimeter of the photonic chip to provide a fillet. The underfill material is cured and solidified following the dispensing operations. Unfortunately, conventional fillets may be unable to prevent cracking of the back-end-of-line stack of the photonics chip adjacent to the fillet and/or delamination of the fillet.

Improved structures for a packaged photonics chip, and associated methods, are needed.

### SUMMARY

In an embodiment, a structure comprises a photonics chip, a packaging substrate, a plurality of electrical connections disposed in a gap between the photonics chip and the packaging substrate, and a fillet comprising an underfill material. The fillet is disposed to overlap with a portion of the photonics chip adjacent to the gap, the fillet has a width dimension and a height dimension transverse to the width dimension, and a ratio of the width dimension to the height dimension is greater than or equal to 1.5.

The ratio of the first width dimension to the first height dimension may be less than or equal to 50.

According to one variant, the packaging substrate may have an edge, the photonics chip may have a top surface, and the first portion of the photonics chip may be a first portion of the top surface that may be adjacent to the edge of the packaging substrate.

Further, the packaging substrate may have a second height dimension at the edge, the first portion of the top surface may have a second width dimension, the first height dimension of the first fillet may be less than the second height dimension, and the first width dimension of the first fillet may be less than the second width dimension.

Further, the first width dimension of the first fillet may extend in a first direction parallel to the top surface, and the first height dimension of the first fillet may extend in a second direction perpendicular to the top surface.

Further, the first fillet may extend in the second direction along the edge of the packaging substrate. Further, the packaging substrate may have a surface that adjoins the gap, and the structure may further comprise a solder mask layer on the surface of the packaging substrate, wherein the first fillet may extend above the solder mask layer.

Further, the top surface of the photonics chip may include a second portion disposed in the gap between the photonics chip and the packaging substrate.

According to another variant, the packaging substrate may have a surface, the photonics chip may have a side surface, and the first portion of the photonics chip may be a first portion of the side surface that is adjacent to the surface of the packaging substrate.

Further, the first width dimension of the first fillet may extend in a first direction perpendicular to the side surface, and the first height dimension of the first fillet may extend in a second direction parallel to the side surface. Additionally or alternatively, the photonics chip may comprise a substrate and a back-end-of-line stack on the substrate, and the first fillet may be coextensive with the substrate over a distance that is greater than or equal to 35 microns and less than or equal to 65 microns.

Further, the surface of the packaging substrate may include a second portion disposed in the gap between the photonics chip and the packaging substrate.

According to another variant, the structure may further comprise a second fillet comprising the underfill material, the second fillet disposed to overlap with a second portion of the photonics chip, the second fillet having a second width dimension and a second height dimension transverse to the second width dimension, and a ratio of the second width dimension to the second height dimension is greater than or equal to 1.5.

Further, the packaging substrate may have an edge, the photonics chip may have a top surface, and the first portion of the photonics chip may be a first portion of the top surface that is adjacent to the edge of the packaging substrate.

Further, the packaging substrate may have a surface, the photonics chip have a side surface, and the second portion of the photonics chip may be a portion of the side surface that is adjacent to the surface of the packaging substrate.

Further, the first fillet may be different from the second fillet.

Independent of the above variants, the structure may further comprise a lid including a first portion that adjoins the photonics chip and a second portion that adjoins the packaging substrate. The lid may include a third portion between the first portion and the second portion, the third portion of the lid may be spaced from the packaging substrate to define an open space, and the first fillet may be disposed in the open space.

Further, the packaging substrate may have an edge, the photonics chip may have a top surface and a bottom surface opposite to the top surface, the first portion of the photonics chip may be a first portion of the top surface of the photonics chip that is adjacent to the edge of the packaging substrate, and the first portion of the of the lid may be adjoined to the bottom surface of the photonics chip.

In an embodiment, a method comprises attaching a photonics chip to a packaging substrate by a plurality of electrical connections. The electrical connections are disposed in a gap between the photonics chip and the packaging substrate. The method further comprises forming a fillet that comprises an underfill material. The fillet overlaps with a portion of the photonics chip adjacent to the gap, the fillet has a width dimension and a height dimension transverse to the width dimension, and a ratio of the width dimension to the height dimension is greater than or equal to 1.5.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals are used to indicate like features in the various views.
FIG. 1 is a cross-sectional view of a package assembly in accordance with embodiments of the invention.
FIG. 2 is an enlarged view of a portion of FIG. 1.
FIG. 3 is an enlarged view of a portion of FIG. 1.

### DETAILED DESCRIPTION

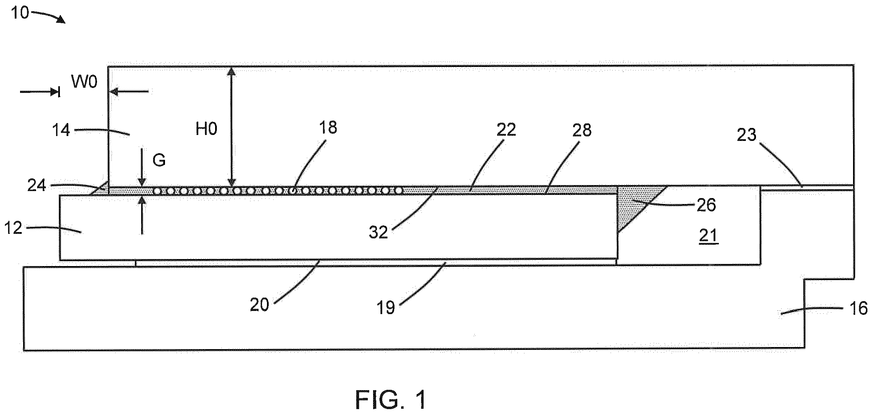

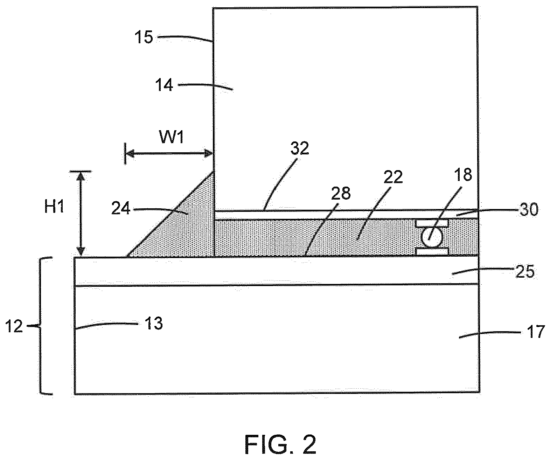

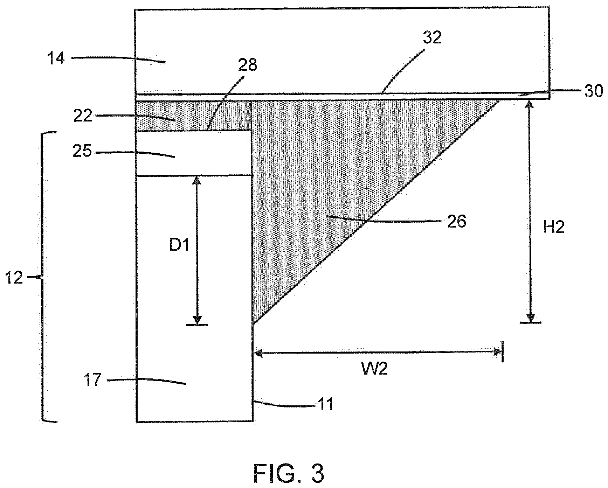

With reference to FIGS. 1, 2, 3 and in accordance with embodiments of the invention, a structure 10 for a lidded package assembly includes a photonics chip 12, a laminate substrate 14 that provides a representative packaging substrate, and a lid 16. The photonics chip 12 is disposed between the laminate substrate 14 and the lid 16. The laminate substrate 14 may include an epoxy-glass cloth core and alternating layers of metal and electrical insulator that are laminated to the core. In an embodiment, the laminate substrate 14 may include layers of a copper film that alternative with layers of an insulating resin, such as Ajinomoto Build-up Film (ABF). A build-up of the alternating layers of the laminate substrate 14 may be disposed adjacent to the photonics chip 12.

The photonics chip 12 includes photonic components, such as modulators, polarizers, and optical couplers, arranged in a functional photonic integrated circuit that is configured to manipulate light received from a light source, such as an optical fiber or a laser. The photonics chip 12 includes a substrate 17 on which the photonic integrated circuit is disposed and a back-end-of-line stack 25 disposed on the substrate 17. The substrate 17 may be comprised of, for example, silicon. The back-end-of-line stack 25, which may include bond pads, an inorganic passivation layer (e.g., a layer of TEOS silicon dioxide), a set of interlayer dielectric layers, and interconnects in the interlayer dielectric layers, may be disposed adjacent to the laminate substrate 14.

The laminate substrate 14 includes bond pads that are coupled by vias to the metal layers in the build-up. A surface 32 of the laminate substrate 14, which is adjacent to a top surface 28 of the photonics chip 12, may be coated by a solder mask layer 30 that is coterminous with an edge 15 of the laminate substrate 14. The laminate substrate 14 has a height H0 at the edge 15. Electrical connections 18 that couple the bond pads of the photonics chip 12 to the bond pads of the laminate substrate 14 are arranged in a gap G between the top surface 28 of the photonics chip 12 and the surface 32 of the laminate substrate 14. The electrical connections 18 may include reflowed solder that originates from either solder balls or solder-capped pillars.

The photonics chip 12 also includes a bottom surface 20 that is opposite to the top surface 28, a side surface 11, and a side surface 13 that is opposite to the side surface 11. The side surfaces 11, 13 are connected by the bottom surface 20 and the top surface 28. The photonics chip 12 includes a portion that is disposed between the side surface 13 and the edge 15 of the laminate substrate 14. The top surface 28 of this portion of the photonics chip 12 is exposed due to a lateral offset in the attachment of the photonics chip 12 to the laminate substrate 14, and the exposed top surface 28 has a width W0. The back-end-of-line stack 25 of the photonics chip 12 may be coextensive with the top surface 28 such that the bond pads are disposed adjacent to the top surface 28.

The lid 16, which may be comprised of an electrically-conductive and thermally-conductive material, such as nickel-coated copper, is attached to same side of the laminate substrate 14 as the photonics chip 12. The photonics chip 12 overlaps with a portion of the lid 16. A layer 19 of thermal interface material may be disposed between the photonics chip 12 and the overlapped portion of the lid 16. The thermal interface material in the layer 19 may be comprised of, for example, a thermal adhesive or a thermal grease that functions to improve heat flow between the photonics chip 12 and the overlapped portion of the lid 16.

Another portion of the lid 16 may be attached to a portion of the surface 32 of the laminate substrate 14 by an adhesive layer 23. An open space 21 is disposed between the side surface 11 of the photonics chip 12, the lid 16, and a portion of the surface 32 of the laminate substrate 14. The different portions of the lid 16 are characterized by a vertical offset that accommodates the placement of the photonics chip 12 between the laminate substrate 14 and the lid 16. The attachment of the portion of the lid 16 to the laminate substrate 14 adds mechanical strength to the structure 10 and, if the adhesive constituting the adhesive layer 23 is conductive, may provide a conductive path from the lid 16 to the laminate substrate 14.

A layer 22 comprised of an underfill material is disposed in the gap G between the photonics chip 12 and the laminate substrate 14 that includes the electrical connections 18. The layer 22 may have a thickness that is substantially equal to the height dimension of the gap G. The layer 22 protects the electrical connections 18 against various adverse environmental factors, redistributes mechanical stresses due to shock, and prevents the electrical connections 18 from moving under strain during thermal cycles when the photonics chip 12 is operating.

A fillet 24 comprised of an underfill material is disposed on a portion of the top surface 28 of the photonics chip 12 adjacent to the edge 15 of the laminate substrate 14 and adjacent to the gap G. The fillet 24 is also disposed on a portion of the edge 15 and covers an opening to the gap G. A fillet 26 comprised of an underfill material is disposed on a portion of the side surface 11 of the photonics chip 12 adjacent to the surface 32 of the laminate substrate 14 and adjacent to the gap G. The fillet 26 is also disposed on a portion of the surface 32 and covers another opening to the gap G.

The underfill material of the layer 22 and fillets 24, 26 may include a bulk matrix and a filler that is dispersed in the bulk matrix. The bulk matrix may be comprised of, for example, a curable thermoplastic resin that is an electrical insulator and non-conductive. The filler may be small particles comprised of an electrical insulator like silica, glass, alumina, or boron nitride. After application, the bulk matrix may be hardened by a curing process to form a cohesive solidified mass. The filler may function to improve the mechanical properties of the cured underfill material and/or to increase the thermal conductivity of the cured underfill material.

The layer 22 and fillets 24, 26 may be formed by a molding process in which the flip-chip assembly including the photonics chip 12 and the laminate substrate 14 is placed inside the cavity of a mold, and fluid underfill material is injected into the mold cavity at an elevated pressure and elevated temperature. The shape of the fillets 24, 26 will conform to the shape of the mold. The photonics chip 12 may include a groove adjacent to the fillet 24 that is configured to receive an optical fiber as a light source for the photonic integrated circuit of the photonics chip 12 and the photonic integrated circuit of the photonics chip 12 may include a spot-size converter that receives the light (e.g., infrared light) from the optical fiber. The lid 16 is attached following the molding process.

The fillet 24 may have a height dimension H1 measured relative to the top surface 28 of the photonics chip 12 and a width dimension W1 measured relative to the edge 15 of the laminate substrate 14. In an embodiment, the ratio of the width dimension W1 to the height dimension H1 may be greater than or equal to 1.5. In an embodiment, the ratio of the width dimension W1 to the height dimension H1 may be greater than or equal to 1.5 and less than or equal to 50. A width-to-height ratio in one or the other of these ranges may be effective to reduce strain in the back-end-of-line stack 25 of the photonics chip 12 and reduce or eliminate failures due to stress-induced crack formation in the back-end-of-line stack 25. In an embodiment, the minimum value of the height dimension H1 of the fillet 24 may be selected such that the fillet 24 projects upward beyond the level of the solder mask layer 30 such that the height dimension H1 is greater than the thickness of the layer 22. In an embodiment, the selection of the minimum value of the height dimension H1 may be used to derive a minimum value for the width dimension W1. For example, if the height dimension H1 of the fillet 24 is 80 microns, the width dimension W1 of the fillet 24 is greater than or equal to 120 microns. The height dimension H1 of the fillet 24 has a maximum value that may constrained by the smaller of the height H0 of the laminate substrate 14 at the edge 15 and the width W0 of the exposed portion of the top surface 28 of the photonics chip 12 between the edge 15 and the side surface 13 of the photonics chip 12.

The fillet 26, which is disposed in the open space 21, may have a height dimension H2 measured relative to the solder mask layer 30 on the bottom surface 29 of the laminate substrate 14 and a width dimension W2 measured relative to the side surface 11 of the photonics chip 12. In an embodiment, the ratio of the width dimension W2 to the height dimension H2 may be greater than or equal to 1.5. In an embodiment, the ratio of the width dimension W2 to the height dimension H2 may be greater than or equal to 1.5 and less than or equal to 50. A ratio in one or the other of these ranges may be effective to reduce strains to the back-end-of-line stack 25 of the photonics chip 12 and reduce or eliminate failures due to delamination of the fillet 26. In an embodiment, the fillet 26 may overlap in the height dimension with a portion of the side surface 11 that is coextensive with the substrate 17 of the photonics chip 12 over a distance D1 that is greater than or equal to 35 microns and less than or equal to 65 microns. In an embodiment, the value of the height dimension H2 may be used to derive a value for the width dimension W2. The height dimension H2 of the fillet 26 may be greater than the thickness of the layer 22.

The fillet 26 is inverted relative to the fillet 24. In an embodiment, the fillet 26 may be different from the fillet 24. In an embodiment, the fillet 26 may be larger than the fillet 24. In an embodiment, the fillet 24 may be larger than the fillet 26. In an embodiment, the fillet 26 may be characterized by a different width-to-height ratio than the fillet 24.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a photonics chip;
a packaging substrate;
a plurality of electrical connections disposed in a gap between the photonics chip and the packaging substrate; and
a first fillet comprising an underfill material, the first fillet disposed to overlap with a first portion of the photonics chip adjacent to the gap, the first fillet having a first width dimension and a first height dimension transverse to the first width dimension,
wherein a ratio of the first width dimension to the first height dimension is greater than or equal to 1.5.

2. The structure of claim 1 wherein the ratio of the first width dimension to the first height dimension is less than or equal to 50.

3. The structure of claim 1 or claim 2 wherein the packaging substrate has an edge, the photonics chip has a top surface, and the first portion of the photonics chip is a first portion of the top surface that is adjacent to the edge of the packaging substrate.

4. The structure of claim 3 wherein the packaging substrate has a second height dimension at the edge, the first portion of the top surface has a second width dimension, the first height dimension of the first fillet is less than the second height dimension, and the first width dimension of the first fillet is less than the second width dimension, and, or wherein the first width dimension of the first fillet extends in a first direction parallel to the top surface, and the first height dimension of the first fillet extends in a second direction perpendicular to the top surface.

5. The structure of claim 4 wherein the first fillet extends in the second direction along the edge of the packaging substrate, and, optionally, wherein the packaging substrate has a surface that adjoins the gap, and the structure further comprises a solder mask layer on the surface of the packaging substrate, wherein the first fillet extends above the solder mask layer.

6. The structure of one of claims 3 to 5 wherein the top surface of the photonics chip includes a second portion disposed in the gap between the photonics chip and the packaging substrate.

7. The structure of claim 1 or claim 2 wherein the packaging substrate has a surface, the photonics chip has a side surface, and the first portion of the photonics chip is a first portion of the side surface that is adjacent to the surface of the packaging substrate.

8. The structure of claim 7 wherein the first width dimension of the first fillet extends in a first direction perpendicular to the side surface, and the first height dimension of the first fillet extends in a second direction parallel to the side surface, and/or wherein the photonics chip comprises a substrate and a back-end-of-line stack on the substrate, and the first fillet is coextensive with the substrate over a distance that is greater than or equal to 35 microns and less than or equal to 65 microns.

9. The structure of claim 7 or claim 8 wherein the surface of the packaging substrate includes a second portion disposed in the gap between the photonics chip and the packaging substrate.

10. The structure of claim 1 or claim 2 further comprising:
a second fillet comprising the underfill material, the second fillet disposed to overlap with a second portion of the photonics chip, the second fillet having a second width dimension and a second height dimension transverse to the second width dimension, and a ratio of the second width dimension to the second height dimension is greater than or equal to 1.5.

11. The structure of claim 10 wherein the packaging substrate has an edge, the photonics chip has a top surface, and the first portion of the photonics chip is a first portion of the top surface that is adjacent to the edge of the packaging substrate, and/or wherein the packaging substrate has a surface, the photonics chip has a side surface, and the second portion of the photonics chip is a portion of the side surface that is adjacent to the surface of the packaging substrate.

12. The structure of claim 10 or claim 11 wherein the first fillet is different from the second fillet.

13. The structure of one of claims 1 to 12 further comprising:
a lid including a first portion that adjoins the photonics chip and a second portion that adjoins the packaging substrate, and, optionally, wherein the lid includes a third portion between the first portion and the second portion, the third portion of the lid is spaced from the packaging substrate to define an open space, and the first fillet is disposed in the open space.

14. The structure of claim 13 wherein the packaging substrate has an edge, the photonics chip has a top surface and a bottom surface opposite to the top surface, the first portion of the photonics chip is a first portion of the top surface of the photonics chip that is adjacent to the edge of the packaging substrate, and the first portion of the of the lid is adjoined to the bottom surface of the photonics chip.

15. A method comprising:
attaching a photonics chip to a packaging substrate by a plurality of electrical connections, wherein the plurality of electrical connections are disposed in a gap between the photonics chip and the packaging substrate; and
forming a fillet comprising an underfill material, wherein the fillet is disposed to overlap with a portion of the photonics chip adjacent to the gap, the fillet has a width dimension and a height dimension transverse to the width dimension, and a ratio of the width dimension to the height dimension is greater than or equal to 1.5.
